# EUROPEAN PATENT APPLICATION

(11) **EP 4 783 758 A1**
(43) Date of publication of application: **29.07.2026**
(21) Application number: 25219018.6
(22) Date of filing: 27.11.2025
(51) Int. Cl.: H05K 7/14

(54) **CHASSIS DEVICE**

(30) Priority: 23.01.2025 CN 202510110233
(71) Applicant: Delta Electronics, Inc., Taoyuan City 33370 (TW)
(72) Inventor: Liu, Hsuan-Ting, 32063 Taoyuan City (TW); Chen, Bo-Yen, 32063 Taoyuan City (TW); Jian, Yan-Hui, 32063 Taoyuan City (TW); Chiu, Shao-Shun, 32063 Taoyuan City (TW); Wu, Kuan-Lung, 32063 Taoyuan City (TW)
(74) Representative: Uexküll & Stolberg

(57) **Abstract**

A chassis device (9, 9a) is disclosed and includes an accommodation space (8, 8a), a chassis unit (1, 1a), a sliding component (2, 2a), a positioning component (3) and a handle component (4). The sliding component (2, 2a) is disposed between the accommodation space (8, 8a) and the chassis unit (1, 1a) along the first direction. The positioning component (3) is arranged in the accommodation space (8, 8a). The chassis unit (1, 1a) includes a guiding groove (11) arranged along the first direction and spatially corresponding to the positioning component (3). When the chassis unit (1, 1a) is placed into the accommodation space (8, 8a) along the first direction, the positioning component (3) is limited to the guiding groove (11). The handle component (4) is pivotally mounted on the chassis unit (1, 1a) and includes a hook end (41) and a holding end (42). When the handle component (4) is in a first position, the hook end (41), the guiding groove (11) and the positioning component (3) are aligned, allowing the hook end (41) engaging the positioning component (3) and driving the handle component (4) to rotate to a second position.

## Description

### FIELD OF THE INVENTION

The present disclosure relates to a chassis structure, and more particularly to a chassis device used in a server room, which has a sliding component and a positioning component arranged between a chassis unit and an accommodation space to achieve the effects of labor saving and positioning.

### BACKGROUND OF THE INVENTION

With the vigorous development of data centers and server rooms, the types of related chassis products are becoming more and more diverse. There are some devices that require a lot of effort to install, such as those that are heavy or have spring structures. For this type of device, in addition to laborious installation, there may also be problems such as scratches on the product due to excessive force during installation.

Therefore, there is a need of providing a chassis device used in a server room, which has a sliding component and a positioning component arranged between a chassis unit and an accommodation space to achieve the effects of labor saving and positioning, sufficiently reduce the force required to install the chassis unit, avoid the collision damage or the scratches, and obviate the drawbacks encountered from the prior arts.

### SUMMARY OF THE INVENTION

It is an object of the present disclosure to provide a chassis device used in a server room, which has a sliding component and a positioning component arranged between a chassis unit and an accommodation space to achieve the effects of labor saving and positioning, sufficiently reduce the force required to install the chassis unit, and avoid the collision damage or the scratches.

It is another object of the present disclosure to provide a chassis device used in a server room. Bearing balls and rollers are used to construct sliding components between the bottom of the accommodation space and the chassis unit to provide sufficient support and achieve labor-saving functions. In addition, the positioning component includes rollers disposed at the top and bottom of the accommodation space and guiding grooves disposed in the chassis unit to achieve both labor-saving and position-limiting functions. It allows the chassis unit being smoothly inserted into or removed from the accommodation space on the chassis device to avoid the collision damage or the scratches on the inner wall of the accommodation space. On the other hand, the handle component is pivotally connected to the front end of the chassis unit and further cooperated with the positioning component when the chassis unit is placed or moved out from the accommodation space. By meshing the arc-shaped engagement groove with the positioning component located in the guiding groove, the handle component is driven to fold or unfold the holding end. It is convenient for users to operate and achieves labor-saving performance. The present disclosure includes the industrial applicability and the inventive steps.

In accordance with an aspect of the present disclosure, a chassis device is provided and includes an accommodation space, a chassis unit, a sliding component, a positioning component and a handle component. The accommodation space includes an opening, wherein the opening faces a first direction. The chassis unit is configured to be placed into or moved out from the accommodation space along the first direction through the opening. The sliding component is disposed between a bottom of the accommodation space and a bottom of the chassis unit along the first direction, wherein the sliding component allows the chassis unit to slide relative to the accommodation space along the first direction, and supports the chassis unit. The positioning component is disposed in the accommodation space, wherein the chassis unit further includes a guiding groove arranged along the first direction, and the guiding groove is spatially corresponding to the positioning component, wherein when the chassis unit is placed into or moved out from the accommodation space along the first direction, the positioning component is limited to the guiding groove. The handle component is pivotally mounted on a front end of the chassis unit and includes a hook end and a holding end opposite to each other, wherein the hook end is spatially corresponding to the positioning component and the guiding groove, and the holding end protrudes from the front end, wherein when the handle component is rotated to a first position, an arc-shaped engagement groove of the hook end is aligned with the guiding groove and the positioning component, and the hook end is allowed engaging the positioning component and driving the handle component to rotate to a second position.

In an embodiment, the positioning component includes a plurality of positioning rollers arranged at intervals along the first direction, the plurality of positioning rollers have axes arranged parallel to a second direction, and the second direction is perpendicular to the first direction.

In an embodiment, the positioning component includes at least one pair of positioning rollers respectively disposed in a central point of a top of the accommodation space and a central point of the bottom of the accommodation space, the at least one pair of positioning rollers have axes arranged parallel to a second direction, and the second direction is perpendicular to the first direction.

In an embodiment, when a rear end of the chassis unit is placed into the accommodation space through the opening, the handle component is pre-rotated to the first position, and the positioning component allows being aligned to a tail end of the guiding groove.

In an embodiment, when the tail end of the guiding groove is close to the positioning component, the handle component is engaged with the positioning component through the arc-shaped engagement groove, and the handle component is driven to rotate to the second position.

In an embodiment, when the handle component is rotated to the second position, the positioning component is limited to the tail end of the guiding groove and engaged with a tail end of the arc-shaped engagement groove, the chassis unit is locked in the accommodation space, and the holding end is retracted to the front end of the chassis unit.

In an embodiment, the arc-shaped engagement groove has a width greater than a diameter of the positioning component, and is tapered from an opening end to the tail end, and the arc-shaped engagement groove further includes a clamping point disposed at the tail end of the arc-shaped engagement groove, wherein when the chassis unit is completely accommodated in the accommodation space, the clamping point is engaged with the positioning component.

In an embodiment, the holding end is forced to unfold from the front end and drive the handle component to rotate from the second position to the first position, the positioning component is limited to the guiding groove and an opening end of the arc-shaped engagement groove, the chassis unit allows being moved out from the accommodation space through the opening.

In an embodiment, the handle component is disposed on the chassis unit through a pivot component, and the pivot component is located between a tail end of the guiding groove and the front end of the chassis unit.

In an embodiment, the hook end is received within the chassis unit, and the holding end protrudes from the front end of the chassis unit through a front opening.

In an embodiment, when the handle component is rotated or swinged, the arc-shaped engagement groove and the guiding groove are at least partially intersected.

In an embodiment, the guiding groove is in communication from a rear end of the chassis unit toward the front end along the first direction.

In an embodiment, the sliding component includes a plurality of bearing balls, the plurality of bearing balls are arranged on the bottom of the chassis unit along the first direction, spatially corresponding to the bottom of the accommodation space, wherein when the chassis unit is placed into or moved out from the accommodation space through the opening along the first direction, the plurality of bearing balls are in contact with the bottom of the accommodation space to support the chassis unit.

In an embodiment, the plurality of bearing balls are arranged in pairs on two opposite sides of the positioning component.

In an embodiment, the sliding component includes a plurality of support rollers, the plurality of support rollers are arranged on two opposite sides of the accommodation space along the first direction, the plurality of support rollers have axes arranged parallel to a third direction, and the first direction is perpendicular to the third direction, wherein the chassis unit includes a pair of recessed portions disposed on two opposite sides, the pair of recessed portions are spatially corresponding to the plurality of support rollers, wherein when the chassis unit is placed into or removed out from the accommodation space through the opening in the first direction, the plurality of support rollers support the chassis unit through the pair of recessed portions.

In an embodiment, the plurality of support rollers are in contact with the bottom of the accommodation space and the bottom of the chassis unit respectively.

In an embodiment, the plurality of support rollers are arranged in pairs on two opposite sides of the positioning component.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is a schematic structural view illustrating a chassis device having a chassis unit completely accommodated in an accommodation space according to a first embodiment of the present disclosure;
FIG. 2 is a schematic structural view illustrating the chassis device having the chassis unit partially separated from the accommodation space according to the first embodiment of the present disclosure;
FIG. 3 is a lateral view illustrating the chassis device having the chassis unit being placed into or moved out from the accommodation space according to the first embodiment of the present disclosure;
FIG. 4 is a rear view illustrating the chassis device having the chassis unit being placed into or moved out from the accommodation space according to the first embodiment of the present disclosure;
FIG. 5 is an enlarged view of region P1 in FIG 4;
FIG. 6 is an enlarged view of region P2 in FIG 4;
FIG. 7 is a schematic diagram showing the handle component rotated to the first position;
FIG. 8 is a schematic diagram showing a transition state of the handle component being rotated from the first position to the second position;
FIG. 9 is a schematic diagram showing the handle component rotated to the second position;
FIG. 10 is a schematic structural view illustrating a chassis device having a chassis unit completely accommodated in an accommodation space according to a second embodiment of the present disclosure;
FIG. 11 is a schematic structural view illustrating the chassis device having the chassis unit partially separated from the accommodation space according to the second embodiment of the present disclosure;
FIG. 12 is a lateral view illustrating the chassis device having the chassis unit being placed into or moved out from the accommodation space according to the second embodiment of the present disclosure;
FIG. 13 is a rear view illustrating the chassis device having the chassis unit being placed into or moved out from the accommodation space according to the second embodiment of the present disclosure;
FIG. 14 is an enlarged view of region P3 in FIG 13; and
FIG. 15 is an enlarged view of region P4 in FIG 13.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed. Further, spatially relative terms, such as "top," "bottom," "front," "rear," "left," "right" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. When an element is referred to as being "connected," or "coupled," to another element, it can be directly connected or coupled to the other element or intervening elements may be present. Although the wide numerical ranges and parameters of the present disclosure are approximations, numerical values are set forth in the specific examples as precisely as possible. In addition, although the "first," "second" and the like terms in the claims be used to describe the various elements can be appreciated, these elements should not be limited by these terms, and these elements are described in the respective embodiments are used to express the different reference numerals, these terms are only used to distinguish one element from another element. For example, a first element could be termed a second element, and, similarly, a second element could be termed a first element, without departing from the scope of example embodiments. Besides, "and / or" and the like may be used herein for including any or all combinations of one or more of the associated listed items.

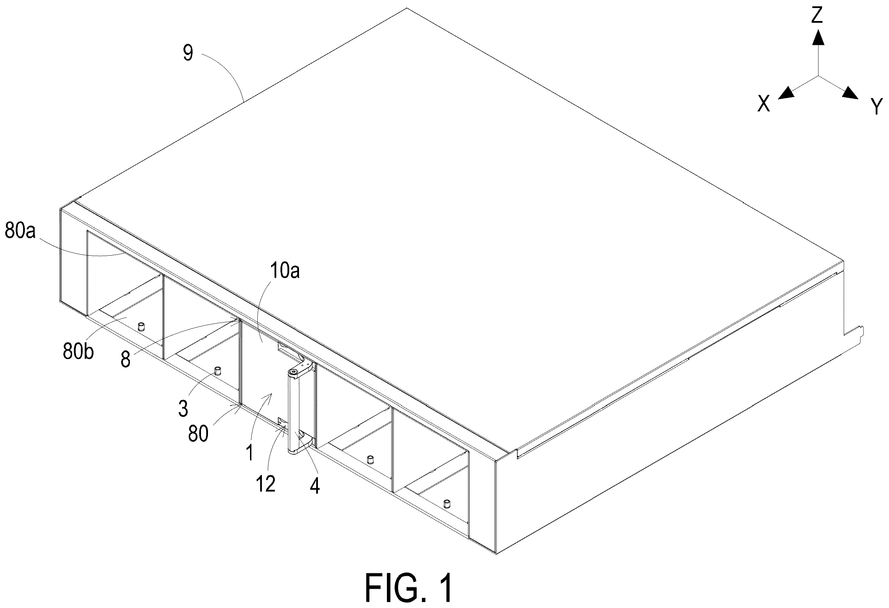

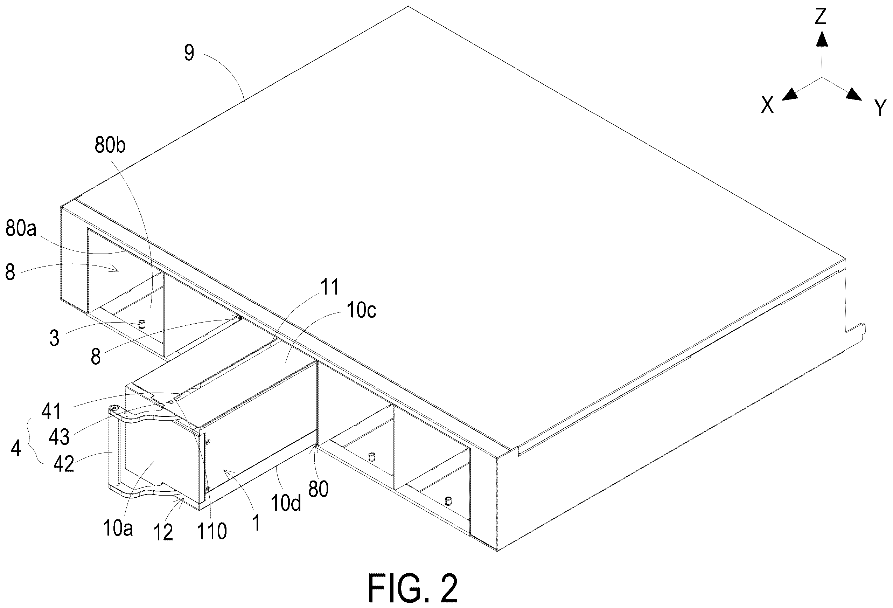

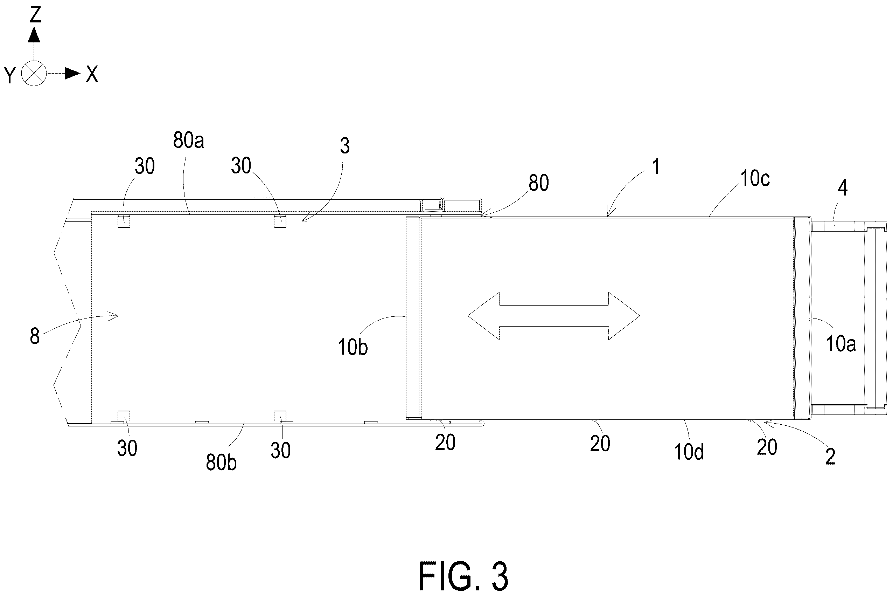

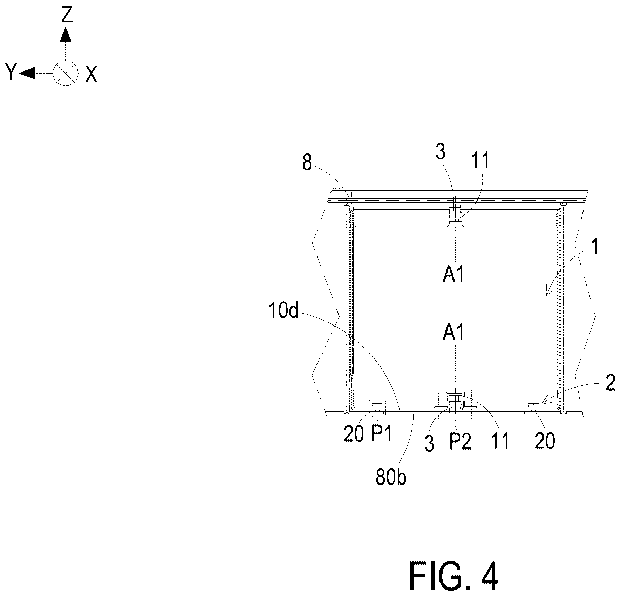

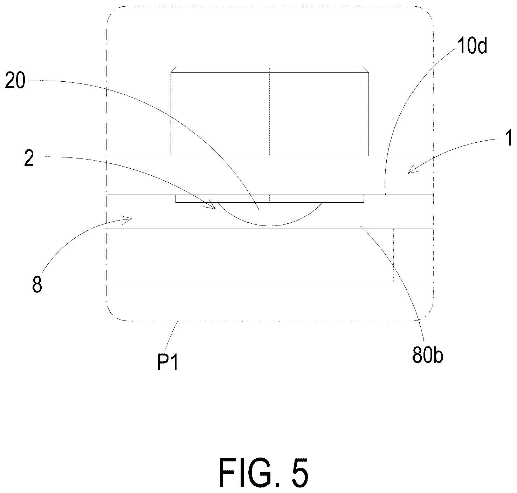

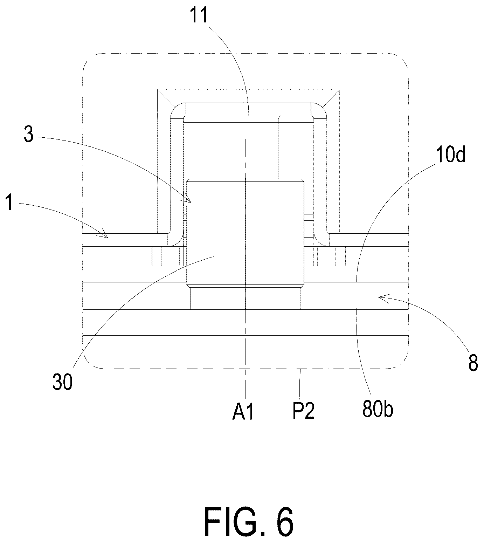

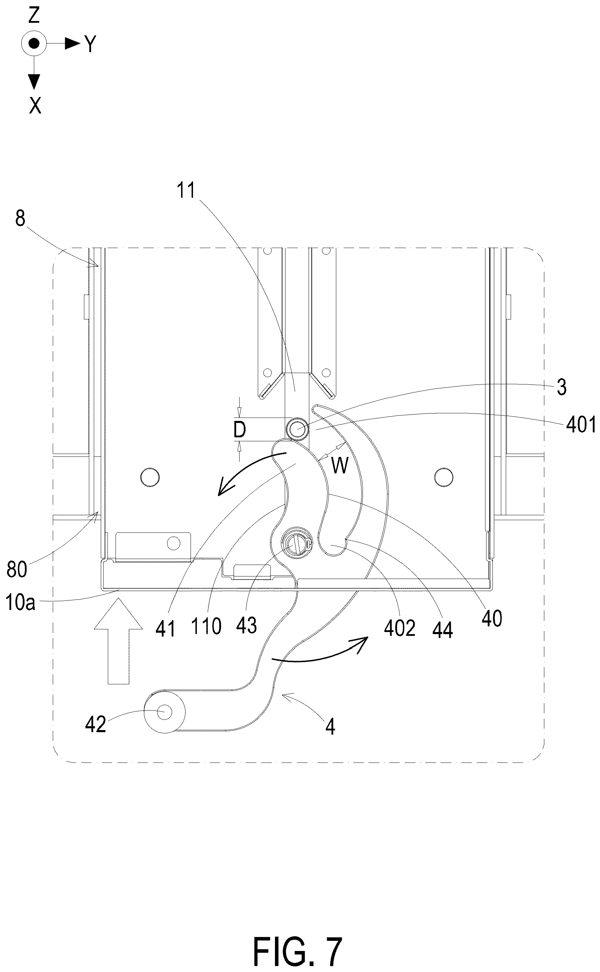

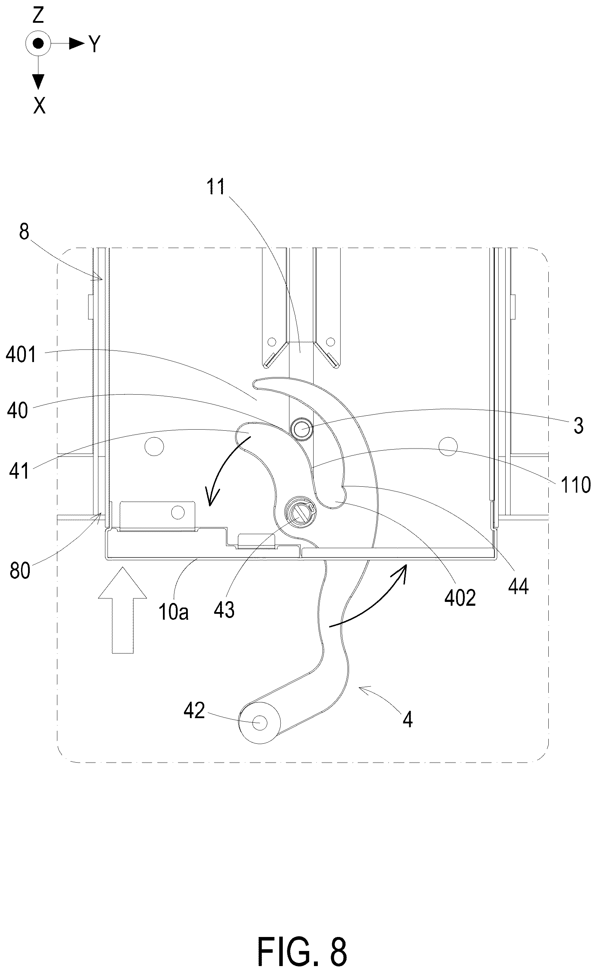

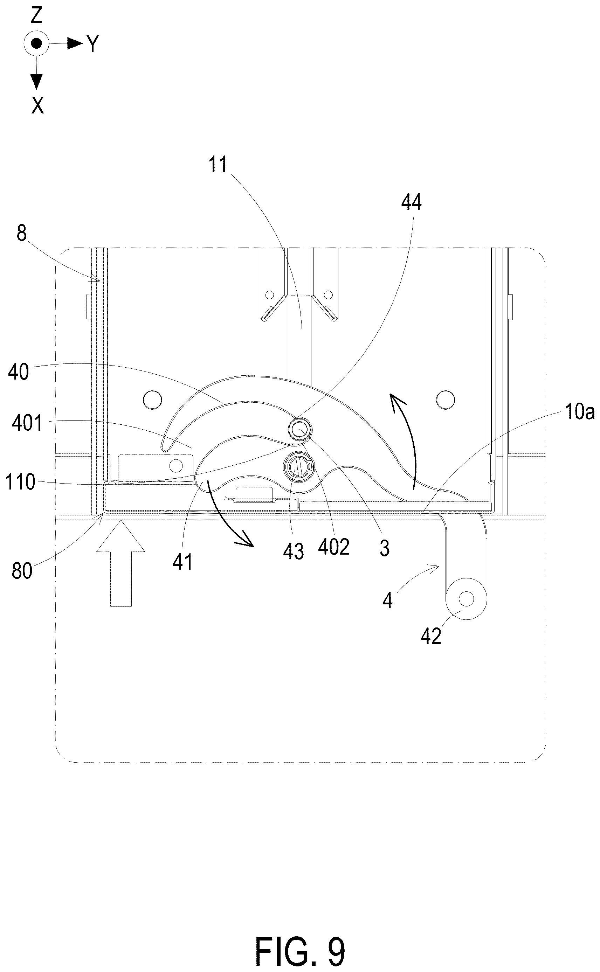

FIG. 1 is a schematic structural view illustrating a chassis device having a chassis unit completely accommodated in an accommodation space according to a first embodiment of the present disclosure. FIG. 2 is a schematic structural view illustrating the chassis device having the chassis unit partially separated from the accommodation space according to the first embodiment of the present disclosure. FIG. 3 is a lateral view illustrating the chassis device having the chassis unit being placed into or moved out from the accommodation space according to the first embodiment of the present disclosure. FIG. 4 is a rear view illustrating the chassis device having the chassis unit being placed into or moved out from the accommodation space according to the first embodiment of the present disclosure. FIG. 5 is an enlarged view of region P1 in FIG 4. FIG. 6 is an enlarged view of region P2 in FIG 4. FIG. 7 is a schematic diagram showing the handle component rotated to the first position. FIG. 8 is a schematic diagram showing a transition state of the handle component being rotated from the first position to the second position. FIG. 9 is a schematic diagram showing the handle component rotated to the second position. Please refer to FIG. 1 to FIG. 9. The present disclosure provides a chassis device 9 used in a server room. The chassis device 9 includes a plurality of accommodation spaces 8 with the same structure arranged in a single row or a multi-row array, and each accommodation space 8 allows one chassis unit 1 to be installed therein. In the embodiment, in addition to at least one accommodation space 8 for paired installation with at least one chassis unit 1, the chassis device 9 further includes a sliding component 2, a positioning component 3 and a handle component 4 for achieving the effects of labor saving and positioning when the chassis unit 1 is installed into the accommodation space 8, sufficiently reducing the force required to install the chassis unit 1, and avoiding the collision damage or the scratches. In the following descriptions only one accommodation space 8 of the chassis device 9 paired with one single chassis unit 8 is taken as an example. The present disclosure is not limited thereto. In the embodiment, the accommodation space 8 includes an opening 80. The opening 80 faces a first direction, such as the X axial direction. The chassis unit 1 includes a rear end 10b, and is configured to be placed into or moved out from the accommodation space 8 along the first direction (i.e., parallel to the X axial direction) by the rear end 10b passing through the opening 80. Preferably but not exclusively, the sliding component 2 includes a plurality of bearing balls 20, which are disposed between a bottom of the accommodation space 8 and a bottom 10d of the chassis unit 1 along the first direction (i.e., parallel to the X axial direction). The sliding component 2 allows the chassis unit 1 to slide relative to the accommodation space 8 along the first direction (i.e., parallel to the X axial direction), and supports the chassis unit 1. In the embodiment, the positioning component 3 is disposed in the accommodation space 8. The chassis unit 1 further includes a guiding groove 11 disposed thereon and arranged along the first direction (i.e., parallel to the X axial direction), and the guiding groove 11 is spatially corresponding to the positioning component 3. In the embodiment, when the chassis unit 1 is placed into or moved out from the accommodation space 8 along the first direction (i.e., parallel to the X axial direction), the positioning component 3 is limited to the guiding groove 11. The handle component 4 is pivotally mounted on a front end 10s of the chassis unit 2 and includes a hook end 41 and a holding end 42 opposite to each other. The hook end 41 is spatially corresponding to the positioning component 3 and the guiding groove 11, and the holding end 42 protrudes from the front end 10a of the chassis unit 1. In the embodiment, when the handle component 4 is rotated to a first position (as shown in FIG. 7), an arc-shaped engagement groove 40 of the hook end 41 is aligned with the guiding groove 11 and the positioning component 3, and the arc-shaped engagement groove 40 of the hook end 41 is allowed engaging the positioning component 3 and driving the handle component 4 to rotate to a second position (as shown in FIG. 9).

In the embodiment, the positioning component 3 includes a plurality of positioning rollers 30. The plurality of positioning rollers 30 are arranged at intervals along the first direction (i.e., parallel to the X axial direction). The plurality of positioning rollers 30 have axes A1 arranged parallel to a second direction (i.e., the Z axial direction), and the second direction is perpendicular to the first direction. In addition, the plurality of positioning rollers 30 of the positioning component 3 are further arranged in pairs. At least one pair of positioning rollers 30 are respectively disposed in a central point of the top 80a and a central point of the bottom 80b of the accommodation space 8. The axes A1 of at least one pair of positioning rollers 30 are arranged parallel to the second direction (i.e., the Z axial direction) and spatially corresponding to the guiding grooves 11 on the top 10c and the bottom 10d of the chassis unit 1, respectively.

In the embodiment, the sliding component 2 includes a plurality of bearing balls 20. The plurality of bearing balls 20 are arranged on the bottom 10d of the chassis unit 1 along the first direction (i.e., parallel to the X axial direction), and spatially corresponding to the bottom 80b of the accommodation space 8. Preferably but not exclusively, the plurality of bearing balls 20 are arranged in pairs and disposed on two opposite sides of the positioning component 3. For example, the plurality of bearing balls 20 are arranged symmetrically at the left side and the right side of the positioning component 3. Certainly, the present disclosure is not limited thereto. In the embodiment, when the chassis unit 1 is inserted into or removed from the accommodation space 8 through the opening 80 along the first direction (i.e., parallel to the X axial direction), the plurality of bearing balls 20 abut the bottom 80b of the accommodation space 8 to support the chassis unit 1. In this way, the contact area between the chassis unit 1 and the accommodation space 8 is reduced, and the displacement of the chassis unit 1 relative to the accommodation space 8 is optimized. Certainly, the present disclosure is not limited thereto.

In the embodiment, when the guiding grooves 11 on the top 10c and the bottom 10d of the chassis unit 1 have the open ends aligned with the positioning component 3, the chassis unit 1 is allowed to be placed into the accommodation space 8 through the opening 80 by the action of the sliding component 2. After the rear end 10b of the chassis unit 1 is placed into the accommodation space 8 through the opening 80, a tail end 110 of the guiding groove 11 is moved toward the positioning component 3. Since the positioning component 3 includes the positioning rollers 30 with the axes A1 parallel to the second direction (i.e., the Z axial direction), when the guiding groove 11 is moved relative to the positioning component 3 along the first direction (i.e., parallel to the X axial direction), the positioning rollers 30 can roll relative to the guiding groove 11 to achieve both labor-saving and position-limiting functions at the same time. Thereby, the chassis unit 1 can be smoothly inserted into or removed from the accommodation space 8 on the chassis device 9, to avoid the collision damage or the scratches on the lateral wall of the chassis unit 1 and the inner wall of the accommodation space 8.

In the embodiment, the handle component 4 includes two hook ends 41 arranged in pairs. The two hook ends 41 are spatially corresponding to the guiding grooves 11 of chassis unit arranged in pairs and the positioning components 3 on the top 80a and bottom 80b of the accommodation space 8. In the following descriptions, only one single hook end 41 corresponding to one single guiding groove 11 and one single positioning component 3 is taken as an example, and the present disclosure is not limited thereto. In the embodiment, when the guiding groove 11 is moved relative to the positioning component 3 along the first direction (i.e., parallel to the X axial direction), the handle component 4 is pre-rotated to the first position (as shown in FIG. 7), and the positioning component 3 allows being aligned to the tail end 110 of the guiding groove 11 and an open end 401 of the arc-shaped engagement groove 40. When the tail end 110 of the guiding groove 11 is close to the positioning component 3, the handle component 4 is engaged with the positioning component 3 through the arc-shaped engagement groove 40, and the handle component 4 is driven to rotate, as shown in FIG. 8. The arc-shaped engagement groove 40 is engaged with the positioning component 3 until the positioning component 3 is limited to the tail end 110 of the guiding groove 11 and engaged with the tail end 402 of the arc-shaped engagement groove 40, and the handle component 4 is driven to rotate to the second position (as shown in FIG. 9).

In the embodiment, when the handle component 4 is rotated to the second position, the positioning component 3 is limited to the tail end 110 of the guiding groove and engaged with the tail end 402 of the arc-shaped engagement groove 40, the chassis unit 1 is locked in the accommodation space 8, and the holding end 42 of the handle component 4 is retracted to the front end 10a of the chassis unit 1.

In the embodiment, the arc-shaped engagement groove 40 has a width W greater than a diameter D of the positioning component 3, and is tapered from the opening end 401 to the tail end 402. When the handle component 4 is rotated from the first position to the second position, the engagement of the handle component 4 and the positioning component 3 is maintained through the arc-shaped engagement groove 40. In the embodiment, the arc-shaped engagement groove 40 further includes a clamping point 44 disposed at the tail end 402 of the arc-shaped engagement groove 40. When the chassis unit 1 is completely accommodated in the accommodation space 8, the clamping point 44 is engaged with the positioning component 3, to ensure that the chassis unit 1 is correctly accommodated in the accommodation space 8.

In the embodiment, the guiding groove 11 is in communication along the first direction (i.e., parallel to the X axial direction) from the rear end 10b toward the front end 10a of the chassis unit 1, but does not run through the front end 10a. In the embodiment, the handle component 4 is disposed on the chassis unit 1 through a pivot component 43 such as a ball bearing. The pivot component 43 is located between the tail end 110 of the guiding groove 11 and the front end 10a of the chassis unit 1.

In the embodiment, when the handle component 4 is rotated or swinged, the arc-shaped engagement groove 40 and the guiding groove 11 are at least partially intersected in the second direction (i.e., the Z axial direction). The intersected place can be used for receiving the positioning component 3 to be limited therein. In the embodiment, the hook end 41 is received in the chassis unit 1, and the holding end 42 protrudes from the front end 10a of the chassis unit 1 through a front opening 12 adjacent to the top 10c and the bottom 10d. The holding end 42 is connected and extended along the second direction. (i.e. the Z axial direction) to facilitate the user's force operation.

In the embodiment, when the user wants to move the chassis unit 1 out of the accommodation space 8, the user can hold the holding end 42 of the handle component 4 and pull the holding end 42 outward. At this time, the holding end 42 of the handle component 4 is forced to protrude outward from the front end 10a of the chassis unit 1. Moreover, at the same time, the positioning component 3 is separated from the clamping point 44 and moved relative to the arc-shaped engagement groove 40. In that, the handle component 4 is driven to rotate from the second position to the first position, and the positioning component 3 is limited to the guiding groove 11 and the open end 401 of the arc-shaped engagement groove 40. It allows the chassis unit 1 to be moved out from the accommodation space 8 through the opening 80. In other words, the handle component 4 pivotally connected to the front end 10a of the chassis unit 1 is further cooperated with the positioning component 3 when the chassis unit 1 is placed into or moved out from the accommodation space 8. The arc-shaped engagement groove 40 and the positioning component 3 positioned in the guiding groove 11 are maintained in engagement with each other, and the handle component 4 is driven to retract or extend the holding end 42. It is convenient for users to operate and achieves labor-saving efficiency.

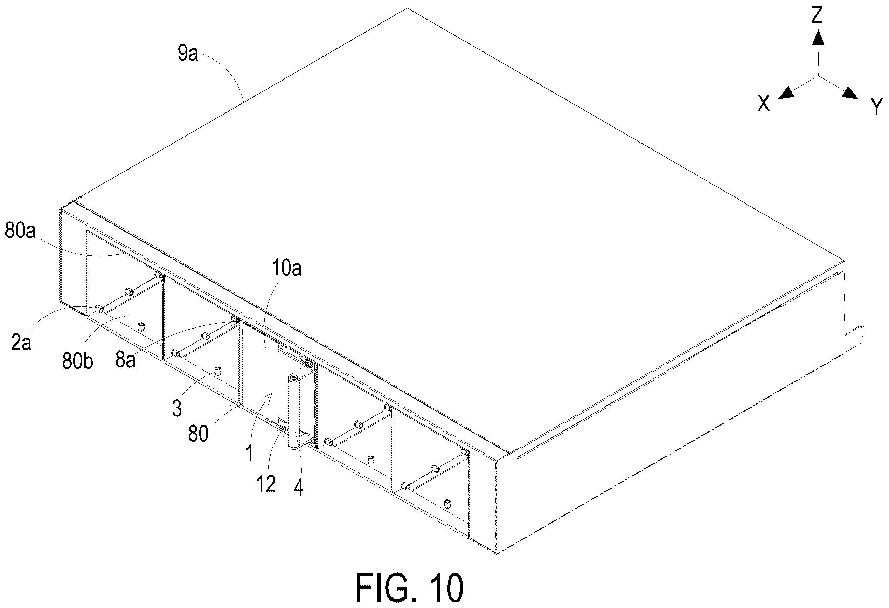

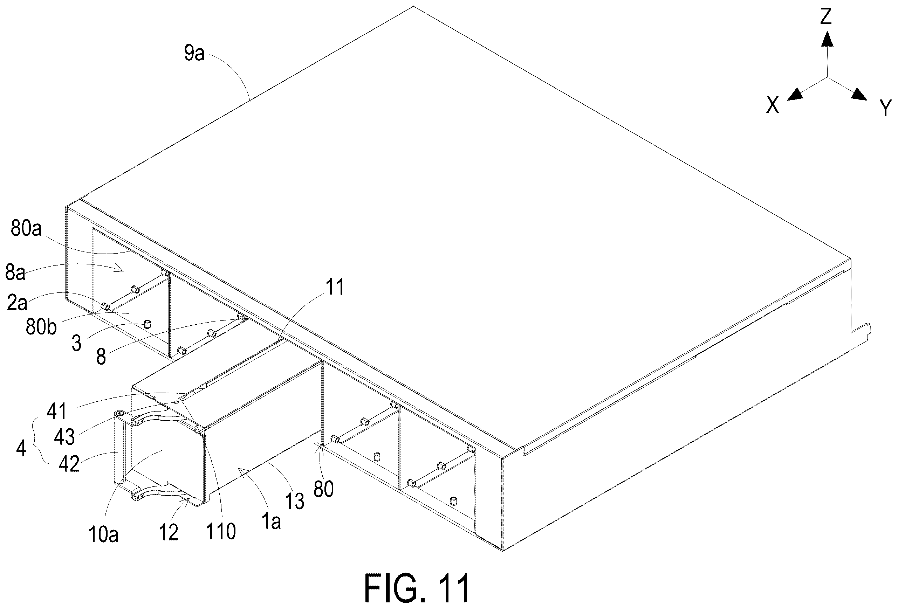

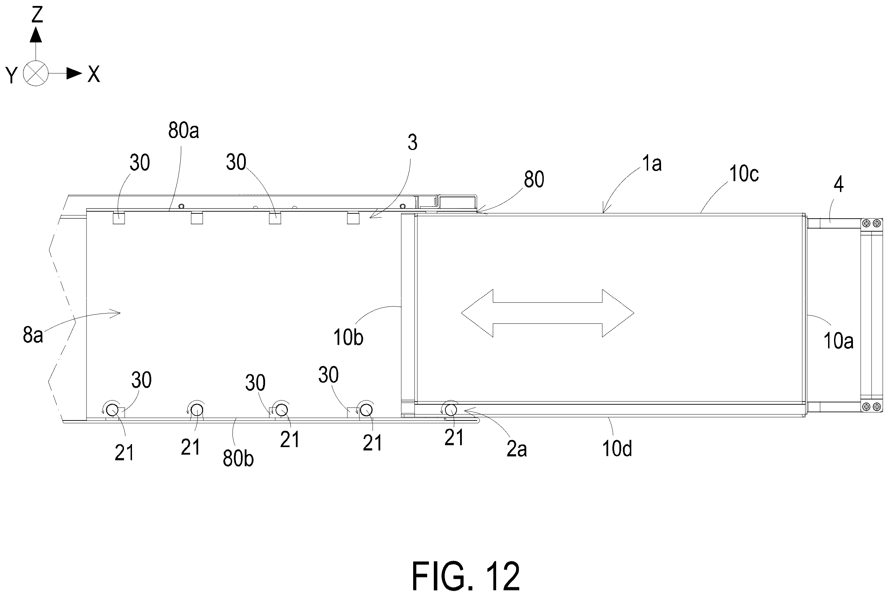

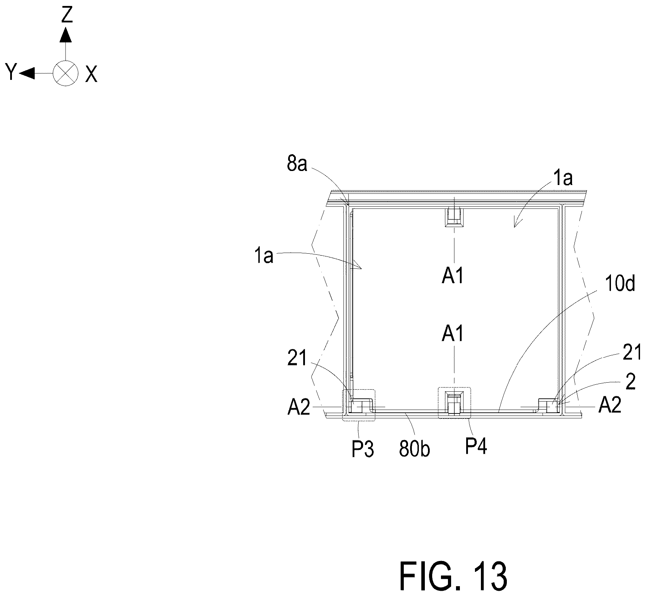

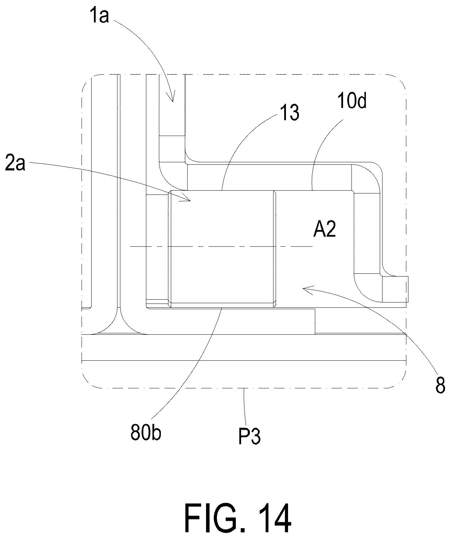

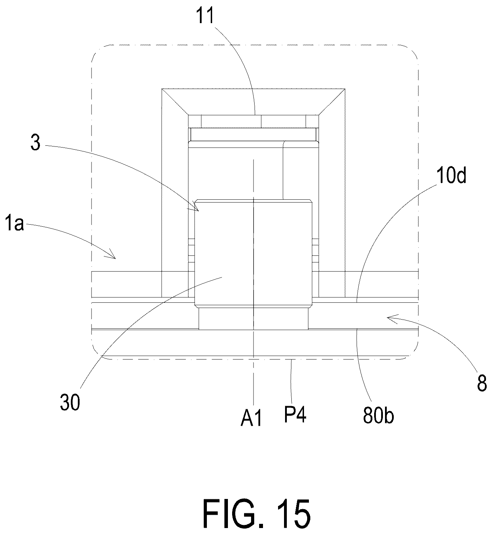

FIG. 10 is a schematic structural view illustrating a chassis device having a chassis unit completely accommodated in an accommodation space according to a second embodiment of the present disclosure. FIG. 11 is a schematic structural view illustrating the chassis device having the chassis unit partially separated from the accommodation space according to the second embodiment of the present disclosure. FIG. 12 is a lateral view illustrating the chassis device having the chassis unit being placed into or moved out from the accommodation space according to the second embodiment of the present disclosure. FIG. 13 is a rear view illustrating the chassis device having the chassis unit being placed into or moved out from the accommodation space according to the second embodiment of the present disclosure. FIG. 14 is an enlarged view of region P3 in FIG 13. FIG. 15 is an enlarged view of region P4 in FIG 13. In the embodiment, the structures, elements and functions of the chassis device 9a, the accommodation space 8a and the chassis unit 1a are similar to those of the chassis device 9, the accommodation space 8 and the chassis unit 1 in FIG. 1 to FIG. 9, and are not redundantly described herein. Please refer to FIG. 7 to FIG. 15. In the embodiment, the sliding component 2a of the chassis device 9a includes a plurality of support rollers 21. The plurality of support rollers 21 are disposed on two opposite sides of the accommodation space 8a along the first direction, arranged in pairs on two opposite sides of the accommodation space 8a, and located adjacent to the bottom 80b of the accommodation space 8a. Preferably but not exclusively, the plurality of support rollers 21 are arranged in pairs on two opposite sides of the positioning assembly 3. For example, the plurality of support rollers 21 are arranged symmetrically at the left side and the right side of the positioning component 3, and the plurality of support rollers 21 have axes A2 parallel to a third direction (i.e., the Y axial direction). In addition, the chassis unit 1a includes a pair of recessed portions 13 disposed on two opposite sides of the bottom 10d. The pair of recessed portions 13 are spatially corresponding to the plurality of support rollers 21. In the embodiment, when the chassis unit 1a is placed into or removed out from the accommodation space 8a by the rear end 10b passing through the opening 80 in the first direction (i.e., parallel to the X axial direction), the plurality of support rollers 21 support the bottom 10d of the chassis unit 1a through the pair of recessed portions 13.

In the embodiment, the plurality of support rollers 21 are in contact with the bottom 80b of the accommodation space 8a and the bottom 10d of the chassis unit 1a respectively. When the guiding grooves 11 on the top 10c and the bottom 10d of the chassis unit 1a have the open ends aligned with the positioning component 3, the chassis unit 1a is allowed to be placed into the accommodation space 8a through the opening 80 by the action of the sliding component 2a. During the rear end 10b of the chassis unit 1a being placed into the accommodation space 8a through the opening 80, the plurality of support rollers 21 of the sliding component 2a are rolling relative to the bottom 10d of the chassis unit 1a, so that a labor-saving function is achieved. Since the positioning component 3 includes the structure of the positioning roller 30, when the rear end 10b of the chassis unit 1a is placed into the accommodation space 8a through the opening 80, the positioning roller 30 can roll relative to the guiding groove 11, so as to achieve labor-saving and position-limiting functions at the same time. Thereby, the chassis unit 1a can be smoothly inserted into or removed from the accommodation space 8a on the chassis device 9a, to avoid the collision damage or the scratches on the lateral wall of the chassis unit 1a and the inner wall of the accommodation space 8a.

In the embodiment, when the chassis unit 1a is placed into or moved out from the accommodation space 8a, the operating method of the handle component 4 is similar to that of the previous embodiment, and not redundantly described herein. Notably, in the embodiment, when the user operates the handle component 4 to place the chassis unit 1a into or move the chassis unit 1a out of the accommodation space 8a, the plurality of support rollers 21 of the sliding component 2a and the positioning rollers 30 of the positioning component 3 are rolling between the chassis unit 1a and the accommodation space 8a, so that both labor-saving and position-limiting functions are achieved at the same time. Thereby, the chassis unit 1a can be smoothly inserted into or removed from the accommodation space 8a on the chassis device 9a, to avoid the collision damage or the scratches on the lateral wall of the chassis unit 1a and the inner wall of the accommodation space 8a. Certainly, the number and the arrangement of the bearing balls 20, the support rollers 21 and the positioning rollers 30 in the aforementioned embodiments are adjustable according to the practical requirements. Certainly, the present disclosure is not limited thereto and not redundantly described hereafter.

In summary, the present disclosure provides a chassis device used in a server room, which has a sliding component and a positioning component arranged between a chassis unit and an accommodation space to achieve the effects of labor saving and positioning, sufficiently reduce the force required to install the chassis unit, and avoid the collision damage or the scratches. Bearing balls and rollers are used to construct sliding components between the bottom of the accommodation space and the chassis unit to provide sufficient support and achieve labor-saving functions. In addition, the positioning component includes rollers disposed at the top and bottom of the accommodation space and guiding grooves disposed in the chassis unit to achieve both labor-saving and position-limiting functions. It allows the chassis unit being smoothly inserted into or removed from the accommodation space on the chassis device to avoid the collision damage or the scratches on the inner wall of the accommodation space. On the other hand, the handle component is pivotally connected to the front end of the chassis unit and further cooperated with the positioning component when the chassis unit is placed or moved out from the accommodation space. By meshing the arc-shaped engagement groove with the positioning component located in the guiding groove, the handle component is driven to fold or unfold the holding end. It is convenient for users to operate and achieves labor-saving performance. The present disclosure includes the industrial applicability and the inventive steps.

## Claims

1. A chassis device (9, 9a), **characterized by** comprising:
an accommodation space (8, 8a), comprising an opening (80), wherein the opening (80) faces a first direction;
a chassis unit (1, 1a), configured to be placed into or moved out from the accommodation space (8, 8a) along the first direction through the opening (80);
a sliding component (2, 2a), disposed between a bottom (80b) of the accommodation space (8, 8a) and a bottom (10d) of the chassis unit (1, 1a) along the first direction, wherein the sliding component (2, 2a) allows the chassis unit (1, 1a) to slide relative to the accommodation space (8, 8a) along the first direction, and supports the chassis unit (1, 1a);
a positioning component (3), disposed in the accommodation space (8, 8a), wherein the chassis unit (1, 1a) further comprises a guiding groove (11) arranged along the first direction, and the guiding groove (11) is spatially corresponding to the positioning component (3), wherein when the chassis unit (1, 1a) is placed into or moved out from the accommodation space (8, 8a) along the first direction, the positioning component (3) is limited to the guiding groove (11); and
a handle component (4), pivotally mounted on a front end (10a) of the chassis unit (1, 1a) and comprising a hook end (41) and a holding end (42) opposite to each other, wherein the hook end (41) is spatially corresponding to the positioning component (3) and the guiding groove (11), and the holding end (41) protrudes from the front end (10a), wherein when the handle component (4) is rotated to a first position, an arc-shaped engagement groove (40) of the hook end (41) is aligned with the guiding groove (11) and the positioning component (3), and the hook end (41) is allowed engaging the positioning component (3) and driving the handle component (4) to rotate to a second position.

2. The chassis device (9, 9a) according to claim 1, wherein the positioning component (3) comprises a plurality of positioning rollers (30) arranged at intervals along the first direction, the plurality of positioning rollers (30) have axes (A1) arranged parallel to a second direction, and the second direction is perpendicular to the first direction.

3. The chassis device (9, 9a) according to claim 1, wherein the positioning component (3) comprises at least one pair of positioning rollers (30) respectively disposed in a central point of a top (80a) of the accommodation space (8, 8a) and a central point of the bottom (80b) of the accommodation space (8, 8a), the at least one pair of positioning rollers (30) have axes (A1) arranged parallel to a second direction, and the second direction is perpendicular to the first direction.

4. The chassis device (9, 9a) according to claim 1, wherein when a rear end (10b) of the chassis unit (1, 1a) is placed into the accommodation space (8, 8a) through the opening (80), the handle component (4) is pre-rotated to the first position, and the positioning component (3) allows being aligned to a tail end (110) of the guiding groove (11).

5. The chassis device (9, 9a) according to claim 4, wherein when the tail end (110) of the guiding groove (11) is close to the positioning component (3), the handle component (4) is engaged with the positioning component (3) through the arc-shaped engagement groove (40), and the handle component (4) is driven to rotate to the second position.

6. The chassis device (9, 9a)according to claim 5, wherein when the handle component (4) is rotated to the second position, the positioning component (3) is limited to the tail end (110) of the guiding groove (11) and engaged with a tail end (402) of the arc-shaped engagement groove (40), the chassis unit (1, 1a) is locked in the accommodation space (8, 8a), and the holding end (42) is retracted to the front end (10a) of the chassis unit (1, 1a).

7. The chassis device (9, 9a) according to claim 6, wherein the arc-shaped engagement groove (40) has a width (W) greater than a diameter (D) of the positioning component (3), and is tapered from an opening end (401) to the tail end (402), and the arc-shaped engagement groove (40) further comprises a clamping point (44) disposed at the tail end (402) of the arc-shaped engagement groove (40), wherein when the chassis unit (1, 1a) is completely accommodated in the accommodation space (8, 8a), the clamping point (44) is engaged with the positioning component (3).

8. The chassis device (9, 9a) according to claim 6, wherein the holding end (42) is forced to unfold from the front end (10a) and drive the handle component (4) to rotate from the second position to the first position, the positioning component (3) is limited to the guiding groove (11) and an opening end (401) of the arc-shaped engagement groove (40), the chassis unit (1, 1) allows being moved out from the accommodation space (8, 8a) through the opening (80).

9. The chassis device (9, 9a) according to claim 1, wherein the handle component (4) is disposed on the chassis unit (1, 1a) through a pivot component (43), and the pivot component (43) is located between a tail end (110) of the guiding groove (11) and the front end (10a) of the chassis unit (1, 1a).

10. The chassis device (9, 9a) according to claim 9, wherein the hook end (41) is received within the chassis unit (1, 1a), and the holding end (42) protrudes from the front end (10a) of the chassis unit (1, 1a) through a front opening (12).

11. The chassis device (9, 9a) according to claim 1, wherein when the handle component (4) is rotated or swinged, the arc-shaped engagement groove (40) and the guiding groove (11) are at least partially intersected.

12. The chassis device (9, 9a) according to claim 1, wherein the guiding groove (11) is in communication from a rear end (10b) of the chassis unit (1, 1a) toward the front end (10a) along the first direction.

13. The chassis device (9, 9a) according to claim 1, wherein the sliding component (2, 2a) comprises a plurality of bearing balls (20), the plurality of bearing balls (20) are arranged on the bottom (10d) of the chassis unit (1, 1a) along the first direction, spatially corresponding to the bottom (80b) of the accommodation space (8, 8a), wherein when the chassis unit (1, 1a) is placed into or moved out from the accommodation space (8, 8a) through the opening (80) along the first direction, the plurality of bearing balls (20) are in contact with the bottom (80b) of the accommodation space (8, 8a) to support the chassis unit.

14. The chassis device (9, 9a) according to claim 13, wherein the plurality of bearing balls (20) are arranged in pairs on two opposite sides of the positioning component (3).

15. The chassis device according to claim 1, wherein the sliding component (2, 2a) comprises a plurality of support rollers (21), the plurality of support rollers (21) are arranged on two opposite sides of the accommodation space (8, 8a) along the first direction, the plurality of support rollers (21) have axes (A2) arranged parallel to a third direction, and the first direction is perpendicular to the third direction, wherein the chassis unit (1, 1a) comprises a pair of recessed portions (13) disposed on two opposite sides, the pair of recessed portions (13) are spatially corresponding to the plurality of support rollers (21), wherein when the chassis unit (1, 1a) is placed into or removed out from the accommodation space (8, 8a) through the opening (80) in the first direction, the plurality of support rollers (21) support the chassis unit (1, 1a)through the pair of recessed portions (13), wherein the plurality of support rollers (21) are in contact with the bottom (80b) of the accommodation space (8, 8a) and the bottom (10d) of the chassis unit (1, 1a) respectively, wherein the plurality of support rollers (21) are arranged in pairs on two opposite sides of the positioning component (3).
